# EUROPEAN PATENT APPLICATION

(11) **EP 3 786 246 A1**
(43) Date of publication of application: **03.03.2021**
(21) Application number: 19793288.2
(22) Date of filing: 18.04.2019
(51) Int. Cl.: C09J 7/29, B32B 27/00, B32B 27/32, C09J 201/00, H01L 21/304

(54) **PRESSURE-SENSITIVE ADHESIVE FILM AND METHOD FOR PRODUCING ELECTRONIC DEVICE**

(30) Priority: 24.04.2018 JP 2018083419
(71) Applicant: Mitsui Chemicals Tohcello, Inc., Tokyo 101-8485 (JP)
(72) Inventor: YASUI Hiroto, Nagoya-shi, Aichi 457-0801 (JP); KURIHARA Hiroyoshi, Nagoya-shi, Aichi 457-0801 (JP)
(74) Representative: Hoffmann Eitle
(86) International application number: PCT/JP2019/016599
(87) International publication number: WO 2019/208378

(57) **Abstract**

The adhesive film (100) of the present invention is an adhesive film used to process an electronic component including a base material layer (10), an unevenness absorbing resin layer (20), and an adhesive resin layer (30), in this order, in which the unevenness absorbing resin layer (20) includes a thermoplastic resin, a melting point (Tm) of the unevenness absorbing resin layer (20) measured by a differential scanning calorimeter (DSC) is in a range of 10°C or higher and 50°C or lower, and the electronic component has a circuit formation surface and the adhesive film is used to grind a surface of the electronic component on an side opposite to the circuit formation surface such that a thickness of the electronic component is 250 µm or less.

## Description

### TECHNICAL FIELD

The present invention relates to an adhesive film and a method for manufacturing an electronic device.

### BACKGROUND ART

In a step of grinding an electronic component among steps of manufacturing an electronic device, an adhesive film is attached to a circuit formation surface of the electronic component in order to fix the electronic component and prevent damage to the electronic component.

For such an adhesive film, a film in which an adhesive resin layer is laminated on a base material film is generally used.

On the other hand, for electronic components with a highly uneven circuit formation surface, in order to impart an unevenness absorbing property to the adhesive film, an adhesive film in which an unevenness absorbing resin layer is provided between the base material film and the adhesive resin layer has been studied.

Examples of techniques relating to adhesive films having such an unevenness absorbing property include the techniques described in Patent Document 1 (JP-A 2014-11273) and Patent Document 2 (JP-A 2010-258426) .

Patent Document 1 describes an adhesive tape for semiconductor wafer processing which has at least one layer or more of a low elastic modulus layer on one surface of a highly elastic base material film, and a radiation-curable adhesive layer on the low elastic modulus layer, in which a Young's modulus of the highly elastic base material film is 5.0x10⁸ Pa to 1.1x10¹⁰ Pa, a storage elastic modulus G' (25°C) of the low elastic modulus layer at 25°C is 2.5 x 10⁵ Pa to 4.0 x 10⁵ Pa and a storage elastic modulus G' (60°C) at 60°C is 0.2 x 10⁵ Pa to 1.5 x 10⁵ Pa, the ratio of G' (60°C) /G' (25°C) is 0. 5 or less, a loss tangent tan δ (25°C) of the low elastic modulus layer at 25°C is 0.08 to 0.15, and a ratio of tan δ (60°C)/tan δ (25°C) with a loss tangent tan δ (60°C) at 60°C is 4.0 or more, a thickness of the radiation-curable adhesive layer is 5 to 100 µm, and a ratio of thicknesses of the low elastic modulus layer and the radiation-curable adhesive layer, which is radiation-curable adhesive layer thickness/low elastic modulus layer thickness, is 1/2 or less.

Patent Document 2 discloses a method of bonding a semiconductor wafer-protecting adhesive sheet, which is obtained by laminating a base material, at least one or more intermediate layers, and an adhesive layer in this order, to the surface of a semiconductor wafer, in which a bonding temperature of the adhesive sheet and the semiconductor wafer is 50°C to 100°C, and a loss tangent (tan δ) of the intermediate layer on the side in contact with the adhesive layer at the bonding temperature is 0.5 or more.

### RELATED DOCUMENT

### PATENT DOCUMENT

[Patent Document 1] Japanese Unexamined Patent Publication No. 2014-11273
[Patent Document 2] Japanese Unexamined Patent Publication No. 2010-258426

### SUMMARY OF THE INVENTION

### TECHNICAL PROBLEM

In recent years, with the spread of System-in-Package (SiP) used in digital mobile devices such as mobile phones, and the like, demand has increased for thin-finish grinding techniques to realize electronic components such as semiconductor wafers with a thickness of 100 µm or less, for example.

According to a study by the present inventors, it was made clear that warping may be generated in the thinly ground electronic components. When the electronic components are warped, there is a concern that troubles may occur in a transfer step or that cracking may be generated in the electronic components.

The present invention was made in view of the above circumstances and provides an adhesive film for processing electronic components, which is capable of suppressing the warping of electronic components after grinding.

### SOLUTION TO PROBLEM

The inventors of the present invention carried out extensive studies in order to achieve the above object. As a result, it was found that, in an adhesive film provided with a base material layer, an unevenness absorbing resin layer, and an adhesive resin layer in this order, using an unevenness absorbing resin layer having a melting point (Tm) in a specific range makes it possible to suppress warping of electronic components after grinding, thereby completing the present invention.

According to the present invention, the following adhesive film is provided.
[1] An adhesive film used to process an electronic component, the film including a base material layer, an unevenness absorbing resin layer, and an adhesive resin layer, in this order, in which the unevenness absorbing resin layer includes a thermoplastic resin, a melting point (Tm) of the unevenness absorbing resin layer measured by a differential scanning calorimeter (DSC) is in a range of 10°C or higher and 50°C or lower, and the electronic component has a circuit formation surface and the adhesive film is used to grind a surface of the electronic component on an side opposite to the circuit formation surface such that a thickness of the electronic component is 250 µm or less.
[2] The adhesive film according to [1], in which a storage elastic modulus G' of the unevenness absorbing resin layer at 70°C measured by a dynamic viscoelasticity measuring device (torsion mode) is 1.0x10⁴ Pa or more and 1.0x10⁶ Pa or less.
[3] The adhesive film according to [1] or [2], in which a heat shrinkage ratio of the base material layer when heat treated at 150°C for 30 minutes is 0.05% or more and 1.2% or less.
[4] The adhesive film according to any one of [1] to [3], in which the thermoplastic resin includes an ethylene/α-olefin copolymer.
[5] The adhesive film according to [4], in which the thermoplastic resin further includes an ethylene/polar monomer copolymer.
[6] The adhesive film according to [5], in which the ethylene/polar monomer copolymer includes an ethylene/vinyl acetate copolymer.
[7] The adhesive film according to [5] or [6], in which, when a total amount of the ethylene/α-olefin copolymer and the ethylene/polar monomer copolymer included in the unevenness absorbing resin layer is 100 parts by mass, a content of the ethylene/polar monomer copolymer in the unevenness absorbing resin layer is 10 parts by mass or more and 70 parts by mass or less.
[8] The adhesive film according to any one of [1] to [7], in which the electronic component has a bump electrode on the circuit formation surface.
[9] A method for manufacturing an electronic device, including at least a preparing step of preparing a structural body provided with an electronic component having a circuit formation surface, and the adhesive film according to any one of [1] to [8], which is bonded to the circuit formation surface side of the electronic component, and a grinding step of grinding a surface of the electronic component on an side opposite to the circuit formation surface side.
[10] The method for manufacturing an electronic device according to [9], in which, in the grinding step, grinding is performed on a surface of the electronic component on an side opposite to the circuit formation surface side until a thickness of the electronic component is 250 µm or less.

### ADVANTAGEOUS EFFECTS OF INVENTION

According to the present invention, it is possible to provide an adhesive film for processing electronic components, which is capable of suppressing warping of electronic components after grinding.

### BRIEF DESCRIPTION OF THE DRAWINGS

The object described above, other objects, features, and advantages will be further clarified by the preferable embodiments described below and the accompanying drawings.
Fig. 1 is a cross-sectional diagram schematically showing an example of a structure of an adhesive film of an embodiment according to the present invention.
Fig. 2 is a schematic diagram for illustrating a bump absorption diameter.

### DESCRIPTION OF EMBODIMENTS

Embodiments of the present invention will be described below, with reference to the drawings. In all the drawings, the same reference numerals are given to the same components and description thereof will not be repeated. In addition, the figures are schematic diagrams and do not match the actual dimensional ratios. A numerical range of "A to B" represents A or more and B or less unless otherwise specified. In addition, in the present embodiment, the meaning of "(meth)acryl" includes both acryl or methacryl, and acryl and methacryl.

### 1. Adhesive Film

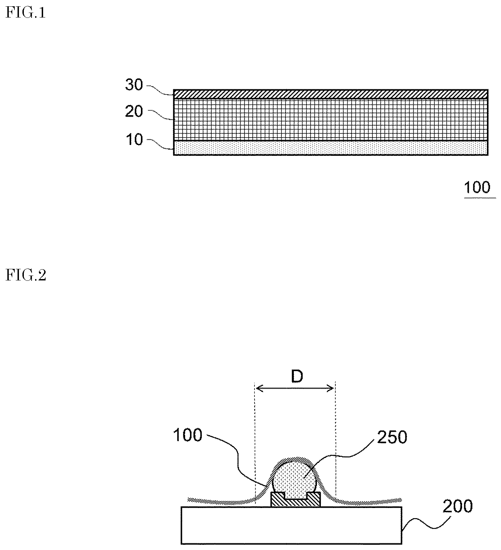

Fig. 1 is a cross-sectional diagram schematically showing an example of a structure of an adhesive film 100 of an embodiment according to the present invention.

As shown in Fig. 1, the adhesive film 100 according to the present embodiment is an adhesive film used to process an electronic component, which is provided with a base material layer 10, an unevenness absorbing resin layer 20, and an adhesive resin layer 30, in this order, in which the unevenness absorbing resin layer 20 includes a thermoplastic resin, a melting point (Tm) of the unevenness absorbing resin layer 20 measured by a differential scanning calorimeter (DSC) is in a range of 10°C or higher and 50°C or lower, and the electronic component has a circuit formation surface and the adhesive film is used to grind a surface of the electronic component on an side opposite to the circuit formation surface such that a thickness of the electronic component is 250 µm or less.

As described above, for electronic components with a highly uneven circuit formation surface, adhesive films provided with an unevenness absorbing resin layer between a base material film and an adhesive resin layer in order to impart an unevenness absorbing property to the adhesive film may be assumed.

Here, in recent years, with the spread of SiP (System-in-Package) used in digital mobile devices such as mobile phones, and the like, demand has increased for thin-finish grinding techniques to realize electronic components such as semiconductor wafers with a thickness of 100 µm or less, for example. However, according to a study by the present inventors, it was made clear that warping may be generated in the thinly ground electronic components. When the electronic components are warped, there is a concern that defects may occur in the transfer step or that cracking may be generated in the electronic components. The present inventors carried out extensive studies in order to achieve the object described above. As a result, it was found for the first time that, in an adhesive film provided with a base material layer, an unevenness absorbing resin layer, and an adhesive resin layer in this order, using an unevenness absorbing resin layer with a melting point (Tm) in a range of 10°C or higher and 50°C or lower makes it possible to suppress warping of electronic components after grinding. That is, according to the present embodiment, providing an unevenness absorbing resin layer 20 with a melting point (Tm) measured by a differential scanning calorimeter (DSC) of 10°C or higher and 50°C or lower between the base material layer 10 and the adhesive resin layer 30 makes it possible to obtain the adhesive film 100 for processing electronic components, which is capable of suppressing warping of the electronic component after grinding.

The reason why it is possible to suppress warping of the electronic component after grinding using the adhesive film 100 according to the present embodiment is not clear, but the following reason may be assumed.

First, according to studies by the present inventors, it was found that, in the step of grinding an electronic component, the temperature of the electronic component and the adhesive film rises due to abrasion of the electronic component, and as a result, the difference between the thermal expansion of the electronic component and the thermal expansion of the adhesive film causes stress in the electronic component, and as a result, warping is generated in the electronic component. The present inventors carried out further studies based on the above findings. As a result, it is assumed that providing the unevenness absorbing resin layer 20 having a melting point (Tm) measured by a differential scanning calorimeter (DSC) in the range of 10°C or higher and 50°C or lower makes it possible to relax stress in the electronic component due to the difference between the thermal expansion of the electronic component and the thermal expansion of the adhesive film and, as a result, it is possible to effectively suppress warping in the electronic component after grinding.

In the adhesive film 100 according to the present embodiment, from the viewpoint of more effectively suppressing the warping of the electronic component after grinding, the storage elastic modulus G' of the unevenness absorbing resin layer 20 at 70°C measured by a dynamic viscoelasticity measuring device (torsion mode) is preferably 1.0x10⁴ Pa or more, more preferably 5.0x10⁴ Pa or more, and even more preferably 1.0x10⁶ Pa or more, and preferably 1.0x10⁶ Pa or less, more preferably 5.0x10⁵ Pa or less, and even more preferably 2.0x10⁵ Pa or less.

It is possible to control the storage elastic modulus G' of the unevenness absorbing resin layer 20 at 70°C in the range described above, for example, by controlling the types and blending ratios of each of the components forming the unevenness absorbing resin layer 20.

In view of the balance between mechanical properties and handleability, the total thickness of the adhesive film 100 according to the present embodiment is preferably 25 µm or more and 1000 µm or less, more preferably 100 µm or more and 800 µm or less, and even more preferably 150 µm or more and 600 µm or less.

In the adhesive film 100 according to the present embodiment, other layers such as an adhesive layer and an antistatic layer (not shown) may be provided between each layer in a range in which the effects of the present invention are not impaired. Using the adhesive layer, it is possible to improve the adhesiveness between each of the layers. In addition, using the antistatic layer, it is possible to improve the antistatic property of the adhesive film 100.

The adhesive film 100 according to the present embodiment is used to protect a surface of an electronic component or to fix the electronic component in a manufacturing step of the electronic device and, more specifically, is suitably used as a back-grinding tape used for protecting a circuit formation surface (that is, a circuit surface including a circuit pattern) of an electronic component in a step of grinding an electronic component (also called a back-grinding step) which is one manufacturing step of an electronic device. Specifically, the adhesive film 100 is used in a step of attaching the adhesive film 100 to the circuit formation surface of the electronic component for protection and grinding the surface on the side opposite to the circuit formation surface. In a case where the circuit formation surface has bump electrodes, it is possible to suitably apply the adhesive film 100 according to the present embodiment provided with the unevenness absorbing resin layer 20.

Here, it is also possible to use the adhesive film 100 according to the present embodiment for processing other than the grinding step. For example, use is possible as a so-called dicing tape for obtaining a plurality of individual semiconductor chips or packages by dicing a semiconductor wafer or an epoxy mold wafer.

In addition, in a case where the electronic component is thinly ground to a thickness of 250 µm or less, warping of the electronic component is likely to occur, thus, the adhesive film 100 according to the present embodiment is particularly suitably used for thinly grinding electronic components such that the thickness of the electronic component is 250 µm or less.

Next, each layer forming the adhesive film 100 according to the present embodiment will be described below.

### <Base Material Layer>

The base material layer 10 is a layer provided for the purpose of improving characteristics such as the handleability, mechanical properties, and heat resistance of the adhesive film 100.

The base material layer 10 is not particularly limited as long as it has a mechanical strength capable of withstanding an external force applied when processing an electronic component, and examples thereof include a resin film.

Examples of the resin forming the base material layer 10 include one or more selected from polyolefins such as polyethylene, polypropylene, poly(4-methyl-1-pentene), and poly(1-butene); polyesters such as polyethylene terephthalate, polybutylene terephthalate, and polyethylene naphthalate; polyamides such as Nylon-6, Nylon-66, and polymethaxylene adipamide; polyacrylate; polymethacrylate; polyvinyl chloride; polyimide; polyetherimide; polyamideimide; ethylene/vinyl acetate copolymers; polyacrylonitrile; polycarbonate; polystyrene; ionomer; polysulfone; polyethersulfone; polyetheretherketone; polyphenylene sulfide; polyphenylene ether; elastomers such as polyester-based elastomers, polyamide-based elastomers, and polyimide-based elastomers; and the like.

Among these, from the viewpoint of improving mechanical properties and transparency, one or more selected from polypropylene, polyethylene terephthalate, polyethylene naphthalate, polyamide, polyimide, ethylene/vinyl acetate copolymers, polyester-based elastomers, polyamide-based elastomers, polyimide-based elastomers, and polybutylene terephthalate are preferable, and one more selected from polyethylene terephthalate and polyethylene naphthalate are more preferable.

A heat shrinkage ratio of the base material layer 10 when heat treated at 150°C for 30 minutes is preferably 0.05% or more and 1.2% or less from the viewpoint of further suppressing warping of the electronic component after grinding, more preferably 0.05% or more and 1.0% or less, and particularly preferably 0.1% or more and 0.6% or less. When the heat shrinkage ratio of the base material layer 10 is the upper limit value described above or less, in a case where the adhesive film 100 is attached to an electronic component under heating or in a case where the temperature of the adhesive film 100 increases during grinding, it is possible to suppress dimensional changes in the base material layer 10, and as a result, it is possible to reduce the stress applied to the electronic component and to further suppress warping of the electronic component. In addition, when the heat shrinkage ratio is the lower limit value described above or more, it is possible to carry out manufacturing with good productivity, which is preferable from the viewpoint of cost performance.

Here, when the length of the base material layer 10 before heat treatment in the flow direction (MD direction) is set to L₀, and the length of the base material layer 10 in the MD direction after carrying out a heat treatment at 150°C for 30 minutes and then cooling at room temperature (23°C) is set to L₁, it is possible to calculate the heat shrinkage ratio of the base material layer 10 by 100x(L₀-L₁)/L₀.

The base material layer 10 may be a single layer or two or more types of layers.

In addition, the form of the resin film used to form the base material layer 10 may be a stretched film or may be a uniaxially or biaxially stretched film; however, from the viewpoint of improving the mechanical strength of the base material layer 10, the film is preferably a uniaxially or biaxially stretched film. The base material layer 10 is preferably annealed in advance from the viewpoint of suppressing warping of the electronic component after grinding. The base material layer 10 may be surface-treated in order to improve the adhesiveness with other layers. Specifically, a corona treatment, a plasma treatment, an undercoat treatment, a primer coat treatment, or the like may be performed.

The thickness of the base material layer 10 is preferably 25 µm or more and 100 µm or less from the viewpoint of obtaining good film characteristics.

### <Unevenness Absorbing Resin Layer>

The adhesive film 100 according to the present embodiment is provided with the unevenness absorbing resin layer 20 between the base material layer 10 and the adhesive resin layer 30.

The unevenness absorbing resin layer 20 is a layer provided for the purpose of improving the conformability of the adhesive film 100 to the circuit formation surface and improving adhesiveness between the circuit formation surface and the adhesive film 100.

The unevenness absorbing resin layer 20 includes a thermoplastic resin and has a melting point (Tm) measured by a differential scanning calorimeter (DSC) of 10°C or higher and 50°C or lower, preferably 15°C or higher and 40°C or lower, and more preferably 15°C or higher and 35°C or lower. The heat of fusion of the unevenness absorbing resin layer 20 measured by a differential scanning calorimeter (DSC) is preferably 10 J/g or more and 100 J/g or less, more preferably 15 J/g or more and 80 J/g or less, and even more preferably 20 J/g or more and 60 J/g or less.

When two or more thermoplastic resin components are included, two or more melting points may be observed, but it is sufficient if at least one melting point (Tm) is in the above range. All of the two or more melting points are preferably 10°C or higher and 50°C or lower.

Regarding the melting point and heat of fusion, in the graph at the time of a second heating when DSC measurement is performed under the following measurement conditions, the temperature which gives the peak top of the endothermic peak is the melting point and the area of the endothermic peak is the heat of fusion.

### <Measurement Conditions>

First heating: Increase temperature from 30°C to 230°C at 10°C/min and hold at 230°C for 5 minutes
Cooling: Decrease the temperature from 230°C to -100°C at 10°C/min and hold at -100°C for 5 minutes
Second heating: Increase temperature again up to 230°C at 10°C/min

The unevenness absorbing resin layer 20 preferably includes an ethylene/α-olefin copolymer (A), and more preferably includes an ethylene/α-olefin copolymer (A) and an ethylene/polar monomer copolymer (B). Due to this, it is possible to more effectively suppress warping of the electronic component after grinding.

In the adhesive film 100 according to the present embodiment, when the total amount of the ethylene/α-olefin copolymer (A) and the ethylene/polar monomer copolymer (B) included in the unevenness absorbing resin layer 20 is 100 parts by mass, the content of the ethylene/polar monomer copolymer (B) in the unevenness absorbing resin layer 20 is preferably 10 parts by mass or more, and more preferably 15 parts by mass or more. In addition, from the viewpoint of more effectively suppressing warping of the electronic component after grinding, the content of the ethylene/polar monomer copolymer (B) in the unevenness absorbing resin layer 20 is preferably 70 parts by mass or less, more preferably 60 parts by mass or less, even more preferably 50 parts by mass or less, yet more preferably 40 parts by mass or less, and particularly preferably 30 parts by mass or less.

### (Ethylene/α-olefin copolymer (A))

The ethylene/α-olefin copolymer (A) according to the present embodiment is, for example, a copolymer obtained by copolymerizing ethylene and an α-olefin having 3 to 20 carbon atoms.

As the α-olefin, for example, it is possible to use an α-olefin having 3 to 20 carbon atoms alone as one type or in a combination of two or more types. Among these, an α-olefin having 10 or less carbon atoms are preferable, and an α-olefin having 3 to 8 carbon atoms are particularly preferable. Specific examples of such an α-olefin include propylene, 1-butene, 1-pentene, 1-hexene, 3-methyl-1-butene, 3,3-dimethyl-1-butene, 4-methyl-1-pentene, 1-octene, 1-decene, 1-dodecene, and the like. Among the above, propylene, 1-butene, 1-pentene, 1-hexene, 4-methyl-1-pentene and 1-octene are preferable because of easy availability. The ethylene/α-olefin copolymer (A) may be a random copolymer or a block copolymer, but a random copolymer is preferable from the viewpoint of flexibility.

Here, examples of the ethylene/α-olefin copolymer (A) include Tafmer (registered trademark) manufactured by Mitsui Chemicals, Inc., ENGAGE (registered trademark) manufactured by DOW, EXACT (registered trademark) manufactured by Exxon Mobil Corporation, Kernel (registered trademark) manufactured by Japan Polyethylene Corporation, and the like.

The density of the ethylene/α-olefin copolymer (A) measured according to ASTM D1505 is preferably 850 to 900 kg/m³, more preferably 850 to 880 kg/m³, and even more preferably 850 to 870 kg/m³.

When the density is the lower limit value described above or more, it is possible to avoid handling problems such as blocking. In addition, when the density is the upper limit value described above or less, it is possible to obtain the unevenness absorbing resin layer 20 having excellent an unevenness absorbing property.

The melt flow rate (MFR) of ethylene/α-olefin copolymer (A) measured according to ASTM D1238 under conditions of 190°C and a load of 2.16 kg is preferably 0.1 to 50 g/10 min, more preferably 0.2 to 30 g/10 min, even more preferably 0.5 to 20 g/10 min, and particularly preferably 1.0 to 10 g/10 min.

When the MFR is the lower limit value described above or more, the fluidity of the ethylene/α-olefin copolymer (A) is improved and it is possible to improve the processability of the unevenness absorbing resin layer 20.

In addition, when the MFR is the upper limit value described above or less, it is possible to obtain the unevenness absorbing resin layer 20 having a more uniform thickness.

### (Ethylene/polar monomer copolymer (B))

Examples of the ethylene/polar monomer copolymer (B) according to the present embodiment include one or more selected from ethylene/unsaturated carboxylic acid ester copolymers such as ethylene/ethyl (meth)acrylate copolymers, ethylene/methyl (meth)acrylate copolymers, ethylene/propyl (meth)acrylate copolymers, ethylene/butyl (meth)acrylate copolymers, ethylene/hexyl (meth)acrylate copolymers, ethylene/-2-hydroxyethyl (meth)acrylate copolymers, ethylene/-2-hydroxypropyl (meth)acrylate copolymers, ethylene/glycidyl (meth)acrylate copolymers, ethylene/dimethyl maleate copolymers, ethylene/diethyl maleate copolymers, ethylene/dimethyl fumarate copolymers, and ethylene/diethyl fumarate copolymers; ethylene/unsaturated carboxylic acid copolymers and salts thereof such as ethylene/(meth)acrylate copolymers, ethylene/maleic acid copolymers, ethylene/fumaric acid copolymers, and ethylene/crotonic acid copolymers; ethylene/vinyl ester copolymers such as ethylene/vinyl acetate copolymers, ethylene/vinyl propionate copolymers, ethylene/vinyl butyrate copolymers, and ethylene/vinyl stearate copolymers, and ethylene/styrene copolymers, and the like.

Among the above, as the ethylene/polar monomer copolymer (B) described above, it is preferable to include one or more selected from ethylene/vinyl ester copolymers and ethylene/unsaturated carboxylic acid ester copolymers from the viewpoint of balance between ease of availability and performance, and it is particularly preferable to include an ethylene/vinyl acetate copolymer.

The ethylene/vinyl acetate copolymer described above is a copolymer of ethylene and vinyl acetate, and is, for example, a random copolymer.

The content ratio of the structural unit derived from vinyl acetate in the ethylene/vinyl acetate copolymer described above is preferably 5% by mass or more and 50% by mass or less, more preferably 10% by mass or more and 45% by mass or less, and even more preferably 15% by mass or more and 40% by mass or less. When the content of vinyl acetate is in this range, the adhesive film 100 is superior in the balance of flexibility, heat resistance, transparency, and mechanical properties. In addition, when forming the film of the unevenness absorbing resin layer 20, the film forming property is good.

It is possible to measure the vinyl acetate content according to JIS K7192:1999.

In addition, the ethylene/vinyl acetate copolymer is preferably a binary copolymer formed only of ethylene and vinyl acetate, but, in addition to ethylene and vinyl acetate, for example, one or more selected from vinyl ester-based monomers such as vinyl formate, vinyl glycolate, vinyl propionate, and vinyl benzoate; acrylic-based monomers or salts or alkyl esters thereof such as acrylic acid, methacrylic acid, and ethacrylic acid; and the like may be included as a copolymer component. In a case where a copolymer component other than the ethylene and vinyl acetate is included, the amount of the copolymer component other than ethylene and vinyl acetate in the ethylene/vinyl acetate copolymer is preferably 0.5% by mass or more and 5% by mass or less.

The melt flow rate (MFR) of the ethylene/polar monomer copolymer (B) measured according to JIS K7210:1999, under conditions of 190°C and a load of 2.16 kg is preferably 0.1 to 50 g/10 min, more preferably 0.2 to 45 g/10 min, and even more preferably 0.5 to 40 g/10 min.

When the MFR is at the lower limit value described above or more, the fluidity of the ethylene/polar monomer copolymer (B) is improved, and it is possible to improve the molding processability of the unevenness absorbing resin layer 20.

In addition, when the MFR is the upper limit value described above or less, the molecular weight becomes high, thus, attachment to the roll surface of a chill roll or the like does not easily occur and it is possible to obtain the unevenness absorbing resin layer 20 having a more uniform thickness.

It is possible to obtain the unevenness absorbing resin layer 20, for example, by dry-blending or melt-kneading the respective components and then carrying out extrusion molding. In addition, it is possible to add an antioxidant as necessary.

The thickness of the unevenness absorbing resin layer 20 is not particularly limited as long as the thickness is able to fill in the unevenness of the circuit formation surface of the electronic component, but, for example, 10 µm or more and 800 µm or less is preferable, 50 µm or more and 600 µm or less is more preferable, and 100 µm or more and 500 µm or less is even more preferable.

### <Adhesive Resin Layer>

The adhesive film 100 according to the present embodiment is provided with an adhesive resin layer 30.

The adhesive resin layer 30 is a layer which is provided on one surface side of the unevenness absorbing resin layer 20 and which contacts and adheres to the circuit formation surface of the electronic component when the adhesive film 100 is attached to the circuit formation surface of the electronic component.

Examples of the adhesive forming the adhesive resin layer 30 include (meth)acrylic-based adhesive, silicone-based adhesive, urethane-based adhesive, olefin-based adhesive, styrene-based adhesive, and the like. Among the above, a (meth)acrylic-based adhesive containing a (meth)acrylic-based resin as a base polymer is preferable in terms of being able to easily adjust the adhesive strength and the like.

In addition, as the adhesive forming the adhesive resin layer 30, it is preferable to use a radiation cross-linking adhesive for which the adhesive strength is reduced by radiation.

The adhesive resin layer 30 formed of a radiation cross-linking adhesive is cross-linked by irradiation of radiation and the adhesive strength is significantly reduced, thus, the electronic component is easily peeled from the adhesive film 100. Examples of the radiation include ultraviolet rays, electron beams, infrared rays, and the like.

As the radiation cross-linking adhesive, an ultraviolet-cross-linking adhesive is preferable.

Examples of the (meth)acrylic-based resin included in the (meth)acrylic-based adhesive include homopolymers of (meth)acrylic acid ester compounds, copolymers of (meth)acrylic acid ester compounds and comonomers, and the like. Examples of the (meth)acrylic acid ester compounds include methyl (meth)acrylate, ethyl (meth)acrylate, butyl (meth)acrylate, 2-ethylhexyl (meth)acrylate, hydroxyethyl (meth)acrylate, hydroxypropyl (meth)acrylate, dimethylaminoethyl (meth)acrylate, glycidyl (meth)acrylate, and the like. These (meth)acrylic acid ester compounds may be used alone as one type or in a combination of two or more types.

In addition, examples of the comonomer forming the (meth)acrylic-based copolymer include vinyl acetate, (meth)acrylonitrile, styrene, (meth)acrylic acid, itaconic acid, (meth)acrylic amide, and methylol (meth)acrylic amide, maleic anhydride, and the like. These comonomers may be used alone as one type or in a combination of two or more types.

Examples of a radiation cross-linking (meth)acrylic-based adhesive include an adhesive including a (meth)acrylic-based resin having a polymerizable carbon-carbon double bond in the molecule, a low-molecular weight compound having two or more polymerizable carbon-carbon double bonds in the molecule, and a photoinitiator, obtained by cross-linking the (meth)acrylic-based resin using a cross-linking agent as necessary.

The (meth)acrylic-based resin having a polymerizable carbon-carbon double bond in the molecule is specifically obtained as follows. First, a monomer having an ethylenic double bond and a copolymerizable monomer having a functional group (P) are copolymerized. Next, the functional group (P) included in this copolymer and a monomer having a functional group (Q) capable of causing an addition reaction, a condensation reaction, or the like with the functional group (P) are reacted with a double bond remaining in the monomer and a polymerizable carbon-carbon double bond is introduced into the copolymer molecule.

As the monomer having an ethylenic double bond, for example, it is possible to use one ore more selected from acrylic acid alkyl esters such as methyl (meth)acrylate, 2-ethylhexyl (meth)acrylate, butyl (meth)acrylate, and ethyl (meth)acrylate, monomers having an ethylenic double bond such as methacrylic acid alkyl ester monomers, vinyl esters such as vinyl acetate, (meth)acrylonitrile, (meth)acrylamide, and styrene.

Examples of the copolymerizable monomer having the functional group (P) include (meth)acrylic acid, maleic acid, 2-hydroxyethyl (meth)acrylate, glycidyl (meth)acrylate, N-methylol (meth)acrylamide, (meth)acryloyloxyethyl isocyanate, and the like.

The above may be used as one type or in a combination of two or more types.

The ratio of the monomer having an ethylenic double bond described above and the copolymerizable monomer having a functional group (P) is 70 to 99% by mass of the monomer having an ethylenic double bond described above, and the copolymerizable monomer having a functional group (P) is preferably 1 to 30% by mass. More preferably, the monomer having an ethylenic double bond described above is 80 to 95% by mass and the copolymerizable monomer having a functional group (P) is 5 to 20% by mass.

Examples of the monomer having the functional group (Q) include the same monomers as the copolymerizable monomer having the functional group (P).

As the combination of the functional group (P) and the functional group (Q) reacted when introducing a polymerizable carbon-carbon double bond into a copolymer of a monomer having an ethylenic double bond and a copolymerizable monomer having a functional group (P), a combination which easily causes an addition reaction is desirable such as a carboxyl group and an epoxy group, a carboxyl group and an aziridyl group, and a hydroxyl group and an isocyanate group. Further, without being limited to an addition reaction, any reaction, such as a condensation reaction between carboxylic acid group and hydroxyl group, may be used as long as the reaction is capable of easily introducing a polymerizable carbon-carbon double bond.

Examples of the low-molecular weight compound having two or more polymerizable carbon-carbon double bonds in the molecule include tripropylene glycol di(meth)acrylate, trimethylolpropane tri(meth)acrylate, tetramethylolmethane tetraacrylate, pentaerythritol tetra(meth)acrylate, dipentaerythritol monohydroxypenta(meth)acrylate, dipentaerythritol hexa (meth) acrylate, and the like. The above may be used as one type or as two or more types. The addition amount of the low-molecular weight compound having two or more polymerizable carbon-carbon double bonds in the molecule is preferably 0.1 to 20 parts by mass with respect to 100 parts by mass of the (meth)acrylic-based resin, and more preferably 5 to 18 parts by mass.

Examples of the photoinitiator include benzoin, isopropylbenzoin ether, isobutylbenzoin ether, benzophenone, Michler's ketone, chlorothioxanthone, dodecylthioxanthone, dimethylthioxanthone, diethylthioxanthone, acetophenone diethylketal, benzyldimethylketal, 1-hydroxycyclohexylphenylketone, 2-hydroxy-2-methyl-1-phenylpropan-1-one, and the like. These may be used as one type or as two or more types. The addition amount of the photoinitiator is preferably 0.1 to 15 parts by mass with respect to 100 parts by mass of the (meth) acrylic-based resin, and more preferably 5 to 10 parts by mass.

A cross-linking agent may be added to the UV-curable adhesive described above. Examples of the cross-linking agent include epoxy-based compounds such as sorbitol polyglycidyl ether, polyglycerol polyglycidyl ether, pentaerythritol polyglycidyl ether, and diglycerol polyglycidyl ether; aziridine-based compounds such as tetramethylolmethane-tri-β-aziridinyl propionate, trimethylolpropane-tri-p-aziridinylpropionate, N,N'-diphenylmethane-4,4'-bis(1-aziridinecarboxamide), and N,N'-hexamethylene-1,6-bis(1-aziridinecarboxamide) ; isocyanate-based compounds such as tetramethylene diisocyanate, hexamethylene diisocyanate, and polyisocyanate, and the like. The UV-curable adhesive described above may be any of a solvent type, an emulsion type, a hot melt type, and the like.

The content of the cross-linking agent is usually preferably in a range such that the number of functional groups in the cross-linking agent does not exceed the number of functional groups in the (meth)acrylic-based resin. However, in a case where a functional group is newly generated in the cross-linking reaction, in a case where the cross-linking reaction is slow, or the like, the cross-linking agent may be contained in excess as necessary.

The content of the cross-linking agent in the (meth) acrylic-based adhesive is preferably 0.1 part by mass or more and 15 parts by mass or less with respect to 100 parts by mass of the (meth)acrylic-based resin from the viewpoint of improving the balance between the heat resistance and the adhesive strength of the adhesive resin layer 30.

It is possible to form the adhesive resin layer 30, for example, by coating an adhesive coating solution on the unevenness absorbing resin layer 20.

As a method of coating the adhesive coating solution, for example, it is possible to adopt a coating method known in the related art such as a roll coater method, a reverse roll coater method, a gravure roll method, a bar coating method, a comma coater method, or a die coater method. The drying conditions of the coated adhesive are not particularly limited, but it is generally preferable to carry out drying in a temperature range of 80 to 200°C for 10 seconds to 10 minutes. More preferably, drying is carried out at 80 to 170°C for 15 seconds to 5 minutes. In order to sufficiently accelerate the cross-linking reaction between the cross-linking agent and the (meth)acrylic-based resin, after completion of the drying of the adhesive coating solution, heating may be carried out at 40 to 80°C for approximately 5 to 300 hours.

In the adhesive film 100 according to the present embodiment, the thickness of the adhesive resin layer 30 is not particularly limited; however, for example, preferably 1µm or more and 100µm or less, more preferably 3µm or more and 80µm or less, and even more preferably 5µm or more and 60µm or less.

Next, an example of a method for manufacturing the adhesive film 100 according to the present embodiment will be described below.

First, the unevenness absorbing resin layer 20 is formed on one surface of the base material layer 10 by an extrusion laminating method. Next, the adhesive coating solution is coated onto the unevenness absorbing resin layer 20 and dried to form the adhesive resin layer 30, and it is possible to obtain the adhesive film 100.

In addition, the base material layer 10 and the unevenness absorbing resin layer 20 may be formed by coextrusion molding, or the film-like base material layer 10 and the film-like unevenness absorbing resin layer 20 may be formed by lamination.

### 2. Electronic Device Manufacturing Method

The electronic device manufacturing method according to the present embodiment is provided with at least the following two steps.
(A) A preparing step of preparing a structural body provided with an electronic component having a circuit formation surface and the adhesive film 100 bonded to the circuit formation surface side of the electronic component
(B) A grinding step of grinding the surface of the electronic component on an side opposite to the circuit formation surface side.

Then, the adhesive film 100 according to the present embodiment is used as the adhesive film 100. In the method for manufacturing an electronic device according to the present embodiment, the adhesive film 100 according to the present embodiment is used as a so-called back-grinding tape when grinding the back surface of the electronic component.

Each step of the method for manufacturing an electronic device according to the present embodiment will be described below.

### (Step (A))

First, a structure provided with an electronic component having a circuit formation surface and the adhesive film 100 bonded to the circuit formation surface side of the electronic component is prepared.

It is possible to produce such a structure, for example, by peeling the release film from the adhesive resin layer 30 of the adhesive film 100, exposing the surface of the adhesive resin layer 30, and attaching the circuit formation surface of the electronic component on the adhesive resin layer 30.

Here, the conditions for attaching the circuit formation surface of the electronic component to the adhesive film 100 are not particularly limited, but for example, it is possible to set the temperature to 30 to 80°C, the pressure to 0.05 to 0.5 MPa, and the attaching speed to 0.5 to 20 mm/sec.

A step (A) preferably further includes a step (A2) of producing a structure by heating and attaching the adhesive film 100 on the circuit formation surface of the electronic component. Due to this, it is possible to improve the adhesive state between the adhesive resin layer 30 and the electronic component over a long time. The heating temperature is not particularly limited, but is, for example, 60 to 80°C.

It is possible to perform the operation of attaching the adhesive film 100 on the electronic component manually, but in general, it is possible to perform the operation using an apparatus called an automatic sticking machine equipped with a roll-shaped adhesive film.

The electronic component attached to the adhesive film 100 is not particularly limited, but an electronic component having a circuit formation surface is preferable. Examples thereof include a semiconductor wafer, an epoxy mold wafer, a mold panel, a mold array package, a semiconductor substrate, and the like, and a semiconductor wafer and an epoxy mold wafer are preferable.

In addition, examples of semiconductor wafers include silicon wafers, sapphire wafers, germanium wafers, germanium-arsenic wafers, gallium-phosphorus wafers, gallium-arsenic-aluminum wafers, gallium-arsenic wafers, lithium tantalate wafers, and the like, but use in silicon wafers is preferable. An example of the epoxy mold wafer is a wafer produced by an eWLB (Embedded Wafer Level Ball Grid Array) process, which is one of the methods for producing a fan-out type WLP.

The semiconductor wafer and the epoxy mold wafer having a circuit formation surface is not particularly limited, but use is possible in, for example, wafers having circuits such as wiring, capacitors, diodes, or transistors formed on the surface. In addition, the circuit formation surface may be plasma-treated.

The circuit formation surface of the electronic component is an uneven surface due to having electrodes, for example.

In addition, for example, when the electronic device is mounted on the mounting surface, the electrode is bonded to the electrode formed on the mounting surface, such that an electric connection is formed between the electronic device and the mounting surface (mounting surface such as a printed substrate).

Examples of electrodes include bump electrodes such as ball bumps, printed bumps, stud bumps, plated bumps, and pillar bumps. That is, the electrodes are usually convex electrodes. These bump electrodes may be used alone as one type or in a combination of two or more types. The height and diameter of the bump electrodes are not particularly limited, but each is preferably 10 to 400 µm, and more preferably 50 to 300 µm. The bump pitch at that time is also not particularly limited, but is preferably 20 to 600 µm, and more preferably 100 to 500 µm.

In addition, the type of metal forming the bump electrode is not particularly limited, and examples thereof include solder, silver, gold, copper, tin, lead, bismuth, alloys thereof, and the like; however, the adhesive film 100 is preferably used in a case where the bump electrode is a solder bump. These types of metals may be used alone as one type or in a combination of two or more types.

### (Step (B))

Next, the surface of the electronic component on the side opposite to the circuit formation surface side (also referred to below as the back surface) is ground (also called back grinding).

Here, grinding means thinning processing to a predetermined thickness without breaking or damaging the electronic components.

For example, the structure described above is fixed to a chuck table or the like of a grinder and the back surface (circuit non-forming surface) of the electronic component is ground.

In such a back surface grinding operation, electronic components are ground until the thickness becomes 250 µm or less. As necessary, the thickness may be reduced to thinner than 100 µm. The thickness of the electronic component before grinding is appropriately determined according to the diameter, type, and the like of the electronic component, and the thickness of the electronic component after grinding is appropriately determined depending on the size of the chip, the type of circuit, and the like to be obtained.

Here, in a case where the electronic component is thinly ground to a thickness of 250 µm or less, warping is easily generated in the electronic component; however, if the adhesive film 100 according to the present embodiment is used, it is possible to suppress warping of the electronic component.

Accordingly, in the method for manufacturing an electronic device according to the present embodiment, in the grinding step (B), while suppressing the warping of the electronic component, it is possible to perform grinding on the surface of the electronic component on the side to the circuit formation surface side until the thickness of the electronic component is 250 µm or less, preferably 200 µm or less, more preferably 150 µm or less, and even more preferably 100 µm or less.

The thickness of the electronic component according to the present embodiment does not include the height of unevenness such as electrodes. That is, the thickness of the electronic component according to the present embodiment refers to the thickness of the wafer or the substrate.

The back surface grinding method is not particularly limited, but it is possible to adopt a known grinding method. It is possible to perform each grinding while cooling the water by pouring water on the electronic component and the grindstone. As necessary, it is possible to perform a dry polishing step, which is a grinding method using no grinding water, at the end of the grinding step. After completion of the back surface grinding, chemical etching is performed as necessary. Chemical etching is performed by a method in which an electronic component is immersed in a state where the adhesive film 100 is attached in an etching solution selected from the group consisting of an acidic aqueous solution formed of hydrofluoric acid, nitric acid, sulfuric acid, or acetic acid alone, or a mixed solution thereof, an alkaline aqueous solution such as potassium hydroxide aqueous solution or sodium hydroxide aqueous solution. The etching is performed for the purpose of eliminating distortion generated on the back surface of the electronic component, further thinning the electronic component, removing an oxide film or the like, a pretreatment when forming electrodes on the back surface, and the like. The etching solution is appropriately selected according to the purpose described above.

### (Step (C))

In the method for manufacturing an electronic device according to the present embodiment, a peeling step (C) of peeling the adhesive film 100 from the surface of the electronic component may be performed after the grinding step or the chemical etching is completed. It is possible to perform this series of operations manually, but the operations are generally performed by a device called an automatic peeling machine.

The surface of the electronic component after peeling the adhesive film 100 may be cleaned as necessary. Examples of the cleaning method include wet cleaning such as water cleaning and solvent cleaning, dry cleaning such as plasma cleaning, and the like. In the case of wet cleaning, ultrasonic cleaning may be used together therewith. It is possible to appropriately select a cleaning method depending on the contamination state of the surface of the electronic component.

### (Other Steps)

After performing the steps (A) to (C), a step of dicing the electronic components into individual pieces to obtain a semiconductor chip, a step of mounting the obtained semiconductor chips on a circuit board, or the like may be further performed. It is possible to perform these steps based on known information.

Preferable embodiments of the present invention were described above, but these are Examples of the present invention and it is also possible to adopt various configurations other than the above.

### [Examples]

The present invention will be explained with reference to Examples and Comparative Examples below, but the present invention is not limited thereto.

Details relating to the production of the adhesive film are as follows.

### <Resin for Forming Unevenness Absorbing Resin Layer>

Resin 1: Ethylene/propylene copolymer (manufactured by Mitsui Chemicals, Inc., trade name: Tafmer P0275, density: 861 kg/m³, melt flow rate (190°C): 2.9 g/10 minutes)
Resin 2: Ethylene/vinyl acetate copolymer (manufactured by Mitsui DuPont Polychemical Co., Ltd., trade name: Evaflex EV170, vinyl acetate content: 33% by mass, density: 960 kg/m³, melt flow rate (190°C): 1 g/10 min)
Resin 3: Ethylene/vinyl acetate copolymer (manufactured by Mitsui DuPont Polychemical Co., Ltd., trade name: Evaflex EV150, vinyl acetate content: 33% by mass, density: 960 kg/m³, melt flow rate (190°C): 30 g/10 min)

### <Adhesive Polymer (Acrylic-based Resin)>

49 parts by mass of ethyl acrylate, 20 parts by mass of 2-ethylhexyl acrylate, 21 parts by mass of methyl acrylate, 10 parts by mass of glycidyl methacrylate, and 0.5 part by mass of benzoyl peroxide as a polymerization initiator were mixed. The obtained mixture was added dropwise to a nitrogen-substituted flask in which 65 parts by mass of toluene and 50 parts by mass of ethyl acetate were placed at 80°C for 5 hours while stirring, and further stirred for 5 hours to carry out a reaction. After the reaction was completed, the obtained solution was cooled, and 25 parts by mass of xylene, 5 parts by mass of acrylic acid, and 0.5 part by mass of tetradecyldimethylbenzylammonium chloride were added to the cooled solution, and a reaction was carried out at 85°C for 32 hours while blowing air to obtain an adhesive polymer solution.

### <Adhesive Coating Solution for Adhesive Resin Layer>

To 100 parts by mass of the adhesive polymer (solid content), 7 parts by mass of benzyl dimethyl ketal (manufactured by BASF, trade name: Irgacure 651) as a photoinitiator, 1 part by mass of an isocyanate-based cross-linking agent (manufactured by Mitsui Chemicals, Inc., trade name: Olestar P49-75S), and 12 parts by mass of dipentaerythritol hexaacrylate (manufactured by Toagosei Co., Ltd., trade name: Aronix M-400) were added to obtain an adhesive coating solution for the adhesive resin layer.

### [Example 1]

Tafmer P0275 (80 parts by mass) and Evaflex EV170 (20 parts by mass), which were to become the unevenness absorbing resin layer, were dry-blended. Next, on a polyethylene terephthalate film (50 µm), which was to become the base material layer, extrusion-lamination was carried out using a single-screw extruder such that the dry blended product of the unevenness absorbing resin described above had a thickness of 350 µm and a laminated film of the base material layer and the unevenness absorbing resin layer was obtained.

Next, the adhesive coating solution for the adhesive resin layer was coated on a silicone release-treated polyethylene terephthalate film (38 µm), and then dried to form an adhesive resin layer with a thickness of 40 µm. Next, the obtained adhesive resin layer was bonded to the unevenness absorbing resin layer side of the laminated film described above to obtain an adhesive film. Each of the following evaluations was performed on the obtained adhesive film. The obtained results are shown in Table 1.

### <Evaluation>

### (1) Heat Shrinkage Ratio of Base Material Layer

According to JIS C2151, the base material layer was heat treated at 150°C for 30 minutes, and the heat shrinkage ratio of the base material layer was calculated by 100x (L₀-L₁)/L₀. Here, the length in the MD direction of the base material layer 10 before the heat treatment was set to L₀ and the length in the MD direction of the base material layer 10 cooled to room temperature after being heat treated at 150°C for 30 minutes was set to L₁.

### (2) Storage Elastic Modulus G' at 70°C of Unevenness Absorbing Resin Layer

Unevenness absorbing resin layers were overlaid at a thickness of 2 mm and press-molded under the following conditions . The obtained press sheet was cut into a circle with a diameter of 25 mm to obtain a test piece.

### <Press Conditions>

Heating temperature: 200°C, preheating time: 2 min
Main pressing load: 15 MPa, Main pressing time: 2 min
Cooling temperature: 20°C, cooling time: 3 min

Then, using a dynamic viscoelasticity measuring device (manufactured by TA Instruments, product name: ARES-G2), the obtained test piece was interposed between parallel plates having a diameter of 25 mm, and the temperature dependence of dynamic viscoelasticity was measured under the conditions of a temperature increase rate of 5°C/min, a temperature range of 40°C to 150°C, an angular frequency of 6.3 rad/s, and a torsion mode.

From the obtained graphs, the storage elastic modulus G' of the unevenness absorbing resin layer at 70°C was determined.

### (3) Melting Point (Tm) and Heat of Fusion of Unevenness Absorbing Resin Layer

The melting point (Tm) and heat of fusion of the unevenness absorbing resin layer were measured by a differential scanning calorimeter (manufactured by SII, product name: X-DSC7000) according to a differential scanning calorimetry method (DSC). Approximately 10 mg of a sample was placed in an aluminum pan, the temperature was increased from 30°C to 230°C at 10°C/min (first heating), and then held for 5 minutes. Then, the result was cooled to -100°C at 10°C/min, held for 5 minutes, and then the temperature was increased again to 230°C at 10°C/min (second heating) . The melting point (Tm) and the heat of fusion were determined from the endothermic peak in the graph at the time of second heating when the temperature was plotted on the horizontal axis and DSC was plotted on the vertical axis. The melting point was determined from the temperature which gave the peak top of the endothermic peak, and the heat of fusion was determined from the area of the endothermic peak.

### (4) Evaluation of Bump Absorption Diameter

Fig. 2 is a schematic diagram for illustrating the bump absorption diameter. Using a protective tape attaching device for the background (DR3000II, manufactured by Nitto Seiki Co., Ltd.), the adhesive film 100 was applied (table temperature: 70°C, laminating load: 90%, laminating speed: 2 mm/s) to an 8-inch bump wafer 200 (solder bump 250, bump height: 200 µm, bump diameter: 270 µm, bump pitch: 400 µm). The obtained adhesive film-attached wafer was observed with an optical microscope (MX61L, manufactured by Olympus Corporation), and the bump absorption diameter D of the adhesive film was measured from the site where floating was observed in the image measurement mode.

The smaller the bump absorption diameter D is, the smaller the floating and the better the bump absorbing property.

### (5) Warping Amount of Semiconductor Wafer After Grinding

Using a protective tape attaching device for the background (DR3000II, manufactured by Nitto Seiki Co., Ltd.), the adhesive film described above was attached to a 12-inch mirror silicon wafer (table temperature: 70°C, laminating load: 90%, laminating speed: 2 mm/s) . The obtained adhesive film-attached wafer was ground until the silicon wafer had a thickness of 50 µm using a grinder/polisher device (DGP8760, manufactured by Disco Corporation). After grinding, the obtained adhesive film-attached wafer was placed on a flat place with the adhesive film on the upper side, and the warped distance was measured.

### [Example 2]

An adhesive film was produced in the same manner as in Example 1 except that the blending amounts of Tafmer P0275 and Evaflex EV170, which were to become the unevenness absorbing resin layer, were changed to the values shown in Table 1. In addition, each evaluation was performed in the same manner as in Example 1. The obtained results are shown in Table 1.

### [Example 3]

An adhesive film was produced in the same manner as in Example 1 except that the blending amounts of Tafmer P0275 and Evaflex EV170, which were to become the unevenness absorbing resin layer, were changed to the values shown in Table 1. In addition, each evaluation was performed in the same manner as in Example 1. The obtained results are shown in Table 1.

### [Comparative Example 1]

An adhesive film was produced in the same manner as in Example 1 except that Evaflex EV150 was used as the thermoplastic resin forming the unevenness absorbing resin layer. In addition, each evaluation was performed in the same manner as in Example 1 except for (2) the storage elastic modulus G' at 70°C of the unevenness absorbing resin layer shown next. The obtained results are shown in Table 1.

### (2) Storage Elastic Modulus G' at 70°C of Unevenness Absorbing Resin Layer

Evaflex EV150 pellets were press molded to a thickness of 2 mm under the following conditions. The obtained press sheet was cut into a circle with a diameter of 25 mm to obtain a test piece.

### <Press Conditions>

Heating temperature: 180°C, preheating time: 2 min
Main pressing load: 15 MPa, Main pressing time: 2 min
Cooling temperature: 20°C, cooling time: 3 min

Then, using a dynamic viscoelasticity measuring device (manufactured by TA Instruments, product name: ARES-G2), the obtained test piece was interposed between parallel plates having a diameter of 25 mm, and the temperature dependence of dynamic viscoelasticity was measured under the conditions of a temperature increase rate of 5°C/min, a temperature range of 40°C to 150°C, an angular frequency of 6.3 rad/s, and a torsion mode.

From the obtained graph, the storage elastic modulus G' of the unevenness absorbing resin layer at 70°C was obtained.

### [Table 1]

**[Table 1]**

| Item | | | Unit | Example 1 | Example 2 | Example 3 | Comparative Example 1 |
|---|---|---|---|---|---|---|---|
| Composition of unevenness absorbing resin layer | Ethylene/α-olefin copolymer | P0275 | Parts by mass | 80 | 60 | 40 | |
| | Ethylene/polar monomer copolymer | EV170 | Parts by mass | 20 | 40 | 60 | - |
| | | EV150 | Parts by mass | - | - | - | 100 |
| Property of base material layer | Heat shrinkage ratio (after heat treatment at 150°C for 30 minutes) | - | % | 0.4 | 0.4 | 0.4 | 0.4 |
| Property of unevenness absorbing resin layer | Storage elastic modulus G' (70°C) | DMA | Pa | 1.4×10⁵ | 1.6×10⁵ | 1.5×10⁵ | 5.2×10⁴ |
| | Melting point (Tm) | DSC | °C | 23 | 26 | 28 | 59 |
| | Heat of fusion | DSC | J/g | 40 | 43 | 44 | 46 |
| Evaluation results | Bump absorption diameter | - | µm | 280 | 280 | 290 | 340 |
| | Warping after back surface grinding | - | mm | 0.0 | 1.0 | 2.3 | 20.5 |

Here, in a case of using the adhesive films of Examples 1 to 3 using the unevenness absorbing resin layer having a melting point (Tm) measured by a differential scanning calorimeter (DSC) in a range of 10°C or higher and 50°C or lower, the warping amount of the semiconductor wafer after grinding was small, which was a good result. In addition, the bump absorption diameters of the adhesive films of the Examples were close to the 270 µm bump diameter of the bump wafer. That is, the adhesive films of Examples were also excellent in an unevenness absorbing property.

From the above, it is understood that the adhesive film 100 according to the present embodiment, which is provided with a base material layer, an unevenness absorbing resin layer, and an adhesive resin layer in this order, in which the melting point (Tm) of the unevenness absorbing resin layer is in the range of 10°C or higher and 50°C or lower, is able to suppress warping of the semiconductor wafer after grinding and has an excellent unevenness absorbing property.

On the other hand, it is understood that, in the adhesive film of Comparative Example 1 in which the melting point (Tm) of the unevenness absorbing resin layer is higher than 50°C, the amount of warping of the semiconductor wafer after grinding is large, and it is not possible to suppress warping of the semiconductor wafer after grinding. In addition, a bump absorption diameter 70 µm larger than the bump diameter of the wafer was observed. That is, it is understood that the adhesive films of Comparative Examples are inferior to the adhesive films of Examples in the unevenness absorbing property.

This application claims priority based on Japanese Patent Application No. 2018-083419 filed on April 24, 2018, and incorporates the entirety of the disclosure thereof.

## Claims

1. An adhesive film used to process an electronic component, the film comprising:
a base material layer;
an unevenness absorbing resin layer; and
an adhesive resin layer, in this order,
wherein the unevenness absorbing resin layer includes a thermoplastic resin,
a melting point (Tm) of the unevenness absorbing resin layer measured by a differential scanning calorimeter (DSC) is in a range of 10°C or higher and 50°C or lower, and
the electronic component has a circuit formation surface and the adhesive film is used to grind a surface of the electronic component on an side opposite to the circuit formation surface such that a thickness of the electronic component is 250 µm or less.

2. The adhesive film according to claim 1,
wherein a storage elastic modulus G' of the unevenness absorbing resin layer at 70°C measured by a dynamic viscoelasticity measuring device (torsion mode) is 1.0x10⁴ Pa or more and 1.0x10⁶ Pa or less.

3. The adhesive film according to claim 1 or 2,
wherein a heat shrinkage ratio of the base material layer when heat treated at 150°C for 30 minutes is 0.05% or more and 1.2% or less.

4. The adhesive film according to any one of claims 1 to 3,
wherein the thermoplastic resin includes an ethylene/α-olefin copolymer.

5. The adhesive film according to claim 4,
wherein the thermoplastic resin further includes an ethylene/polar monomer copolymer.

6. The adhesive film according to claim 5,
wherein the ethylene/polar monomer copolymer includes an ethylene/vinyl acetate copolymer.

7. The adhesive film according to claim 5 or 6,
wherein, when a total amount of the ethylene/α-olefin copolymer and the ethylene/polar monomer copolymer included in the unevenness absorbing resin layer is 100 parts by mass, a content of the ethylene/polar monomer copolymer in the unevenness absorbing resin layer is 10 parts by mass or more and 70 parts by mass or less.

8. The adhesive film according to any one of claims 1 to 7,
wherein the electronic component has a bump electrode on the circuit formation surface.

9. A method for manufacturing an electronic device, comprising at least:
a preparing step of preparing a structural body provided with an electronic component having a circuit formation surface, and the adhesive film according to any one of claims 1 to 8, which is bonded to the circuit formation surface side of the electronic component; and
a grinding step of grinding a surface of the electronic component on an side opposite to the circuit formation surface side.

10. The method for manufacturing an electronic device according to claim 9,
wherein, in the grinding step, grinding is performed on a surface of the electronic component on an side opposite to the circuit formation surface side until a thickness of the electronic component is 250 µm or less.
